(19) Europäisches Patentamt
European Patent Office
Office européen des brevets

(11) **EP 4 729 217 A1**

(12) **EUROPEAN PATENT APPLICATION**
published in accordance with Art. 153(4) EPC

(43) Date of publication:
**22.04.2026   Bulletin 2026/17**

(21) Application number: **24940697.6**

(22) Date of filing: **08.05.2024**

(51) International Patent Classification (IPC):
**B23B 27/14** $^{(2006.01)}$

(52) Cooperative Patent Classification (CPC):
**B23B 27/14; C23C 16/40**

(86) International application number:
**PCT/JP2024/017150**

(87) International publication number:
**WO 2025/234028 (13.11.2025 Gazette 2025/46)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Sumitomo Electric Industries, Ltd.
Osaka-shi, Osaka 541-0041 (JP)**

(72) Inventors:
• **HARADA, Haruko
  Osaka-shi, Osaka 541-0041 (JP)**
• **KOBAYASHI, Fumiyoshi
  Osaka-shi, Osaka 541-0041 (JP)**
• **PASEUTH, Anongsack
  Osaka-shi, Osaka 541-0041 (JP)**
• **KISHIDA, Yuya
  Osaka-shi, Osaka 541-0041 (JP)**
• **SEKIYA, Takashi
  Osaka-shi, Osaka 541-0041 (JP)**

(74) Representative: **Boult Wade Tennant LLP
Salisbury Square House
8 Salisbury Square
London EC4Y 8AP (GB)**

(54) **CUTTING TOOL**

(57)     A cutting tool includes: a substrate; and a coating film disposed on the substrate, wherein the coating film includes a first layer, the first layer is composed of $\alpha$-$Al_2O_3$, a thickness of the first layer is 2 $\mu$m or more and 15 $\mu$m or less, in a cross section along a normal line of an interface between the substrate and the coating film, the first layer includes a plurality of grain boundaries each connecting an interface of the first layer close to the substrate and a surface of the first layer or an interface of the first layer close to a surface of the coating film, and a first grain boundary, which is at least one of the grain boundaries, has a plurality of straight line portions and three or more bending points each connecting two adjacent straight line portions of the straight line portions, in the first grain boundary, each of an intersection angle A1 at a bending point closest to the interface of the first layer close to the substrate and an intersection angle A2 at a bending point second closest to the interface of the first layer close to the substrate is 120° or more and less than 180°, in the first grain boundary, each of an intersection angle A4 at a bending point closest to the surface of the first layer or the interface of the first layer close to the surface of the coating film and an intersection angle A3 at a bending point second closest to the surface of the first layer or the interface of the first layer close to the surface of the coating film is 90° or more and 150° or less, in the first grain boundary, an average X1 of the intersection angle A1 and the intersection angle A2 and an average X2 of the intersection angle A3 and the intersection angle A4 satisfy a relation of a formula 1, and a ratio N2/N1 of the number N2 of the first grain boundaries to the number N1 of the grain boundaries is 0.2 or more.

EP 4 729 217 A1

FIG.2

**Description**

TECHNICAL FIELD

The present disclosure relates to a cutting tool.

BACKGROUND ART

Conventionally, for a cutting process, there has been used a cutting tool including a substrate and a coating film disposed on the substrate, wherein the coating film includes a first layer, and the first layer is composed of $\alpha$-Al$_2$O$_3$ (PTL 1, NPL 1).

CITATION LIST

PATENT LITERATURE

PTL 1: WO 2015/113866

NON PATENT LITERATURE

NPL 1: S. Ruppi et al., "Influence of Process Conditions on the Growth and Texture of CVD Alpha-Alumina" Coatings 2020, 10, 158

SUMMARY OF INVENTION

A cutting tool of the present disclosure is

a cutting tool comprising: a substrate; and a coating film disposed on the substrate, wherein
the coating film includes a first layer,
the first layer is composed of $\alpha$-Al$_2$O$_3$,
a thickness of the first layer is 2 $\mu$m or more and 15 $\mu$m or less,
in a cross section along a normal line of an interface between the substrate and the coating film, the first layer includes a plurality of grain boundaries each connecting an interface of the first layer close to the substrate and a surface of the first layer or an interface of the first layer close to a surface of the coating film, and a first grain boundary, which is at least one of the grain boundaries, has a plurality of straight line portions and three or more bending points each connecting two adjacent straight line portions of the straight line portions,
in the first grain boundary, each of an intersection angle A1 at a bending point closest to the interface of the first layer close to the substrate and an intersection angle A2 at a bending point second closest to the interface of the first layer close to the substrate is 120° or more and less than 180° ,
in the first grain boundary, each of an intersection angle A4 at a bending point closest to the surface of the first layer or the interface of the first layer close to the surface of the coating film and an intersection angle A3 at a bending point second closest to the surface of the first layer or the interface of the first layer close to the surface of the coating film is 90° or more and 150° or less,
in the first grain boundary, an average X1 of the intersection angle A1 and the intersection angle A2 and an average X2 of the intersection angle A3 and the intersection angle A4 satisfy a relation of a formula 1, and
a ratio N2/N1 of the number N2 of the first grain boundaries to the number N1 of the grain boundaries is 0.2 or more, where

$$X1\text{-}X2 \geq 10° \qquad \text{Formula 1}.$$

BRIEF DESCRIPTION OF DRAWINGS

[Fig. 1] Fig. 1 is a schematic cross sectional view illustrating one implementation of a cutting tool of the present disclosure.
[Fig. 2] Fig. 2 is an enlarged view of a region II in Fig. 1.

[Fig. 3] Fig. 3 is a schematic cross sectional view of an exemplary CVD (Chemical Vapor Deposition) apparatus used to manufacture a cutting tool of the present disclosure.

DETAILED DESCRIPTION

[Problem to be Solved by the Present Disclosure]

In recent years, a demand for improvement in tool life has been increased greatly, and further improvement in tool life has been required particularly in face milling. In particular, "wear resistance" and "chipping resistance" are important factors for improving the tool life in face milling. Moreover, from the viewpoint of improving the "chipping resistance", there has been used a cutting tool comprising: a substrate; and a coating film disposed on the substrate, wherein the coating film includes a first layer, the first layer is composed of $\alpha$-Al$_2$O$_3$, a thickness of the first layer is 2 $\mu$m or more and 15 $\mu$m or less, in a cross section along a normal line of an interface between the substrate and the coating film, the first layer includes a plurality of grain boundaries each connecting an interface of the first layer close to the substrate and a surface of the first layer or an interface of the first layer close to a surface of the coating film, and a first grain boundary, which is at least one of the grain boundaries, has a plurality of straight line portions and three or more bending points each connecting two adjacent straight line portions of the straight line portions. However, in such a cutting tool, since nucleation of $\alpha$-Al$_2$O$_3$, which is strongly oriented in (001), is likely to be unstable in the first layer, it may become difficult to attain strong orientation in the first layer. As a result, it may be difficult to provide excellent "wear resistance" to the first layer. Therefore, it has been required to provide both excellent "wear resistance" and excellent "chipping resistance" to the cutting tool so as to provide an excellent tool life.

Thus, it is an object of the present disclosure to provide a cutting tool having an excellent tool life also particularly in face milling.

[Advantageous Effect of the Present Disclosure]

According to the present disclosure, it is possible to provide a cutting tool having an excellent tool life also particularly in face milling.

[Description of Embodiments]

First, embodiments of the present disclosure will be listed and described.

(1) A cutting tool of the present disclosure is

a cutting tool comprising: a substrate; and a coating film disposed on the substrate, wherein
the coating film includes a first layer,
the first layer is composed of $\alpha$-Al$_2$O$_3$,
a thickness of the first layer is 2 $\mu$m or more and 15 $\mu$m or less,
in a cross section along a normal line of an interface between the substrate and the coating film, the first layer includes a plurality of grain boundaries each connecting an interface of the first layer close to the substrate and a surface of the first layer or an interface of the first layer close to a surface of the coating film, and a first grain boundary, which is at least one of the grain boundaries, has a plurality of straight line portions and three or more bending points each connecting two adjacent straight line portions of the straight line portions,
in the first grain boundary, each of an intersection angle A1 at a bending point closest to the interface of the first layer close to the substrate and an intersection angle A2 at a bending point second closest to the interface of the first layer close to the substrate is 120° or more and less than 180°,
in the first grain boundary, each of an intersection angle A4 at a bending point closest to the surface of the first layer or the interface of the first layer close to the surface of the coating film and an intersection angle A3 at a bending point second closest to the surface of the first layer or the interface of the first layer close to the surface of the coating film is 90° or more and 150° or less,
in the first grain boundary, an average X1 of the intersection angle A1 and the intersection angle A2 and an average X2 of the intersection angle A3 and the intersection angle A4 satisfy a relation of a formula 1, and
a ratio N2/N1 of the number N2 of the first grain boundaries to the number N1 of the grain boundaries is 0.2 or more, where

$$X1\text{-}X2 \geq 10° \quad \text{Formula 1.}$$

According to the present disclosure, it is possible to provide a cutting tool having an excellent tool life also particularly in face milling.

(2) In (1), in the first grain boundary, an average D1 of distances between two adjacent bending points along the normal line of the interface between the substrate and the coating film may be 0.05 $\mu$m or more and 4 $\mu$m or less. Thus, it is possible to provide a cutting tool having a more excellent tool life also particularly in face milling.

(3) In (1) or (2), the thickness of the first layer may be less than 8 $\mu$m, and in the surface of the first layer or a surface of the first layer located at the interface of the first layer close to the surface of the coating film, a surface roughness Ra may be 0.03 $\mu$m or more and 0.2 $\mu$m or less. Thus, it is possible to provide a cutting tool having a more excellent tool life also particularly in face milling.

(4) In (1) or (2), the thickness of the first layer may be 8 $\mu$m or more, and

in the surface of the first layer or a surface of the first layer located at the interface of the first layer close to the surface of the coating film, a surface roughness Ra may be 0.05 $\mu$m or more and 0.2 $\mu$m or less. Thus, it is possible to provide a cutting tool having a more excellent tool life also particularly in face milling.

(5) In any one of (1) to (4), an orientation index TC(0 0 12) of the first layer may be more than 4.5. Thus, it is possible to provide a cutting tool having a more excellent tool life also particularly in face milling.

[Details of Embodiments of the Present Disclosure]

With reference to figures, the following describes specific examples of a cutting tool according to one embodiment (hereinafter, also referred to as "the present embodiment") of the present disclosure. In the figures of the present disclosure, the same reference characters represent the same or corresponding portions. Further, a dimensional relation such as a length, a width, a thickness, or a depth is appropriately changed for clarity and simplification of the figures, and therefore do not necessarily represent an actual dimensional relation.

In the present disclosure, the expression "A to B" represents a range of lower to upper limits (i.e., A or more and B or less), and when no unit is indicated for A and a unit is indicated only for B, the unit of A is the same as the unit of B.

When a compound or the like is expressed by a chemical formula in the present disclosure and an atomic ratio is not particularly limited, it is assumed that all the conventionally known atomic ratios are included, and the atomic ratio should not be necessarily limited only to one in the stoichiometric range.

[First Embodiment: Cutting Tool]

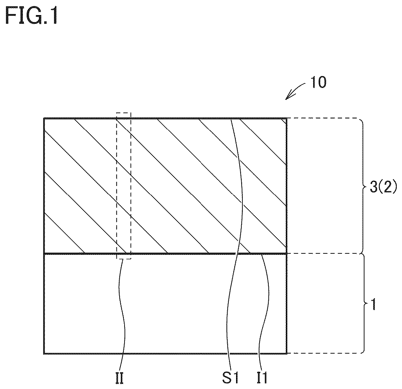

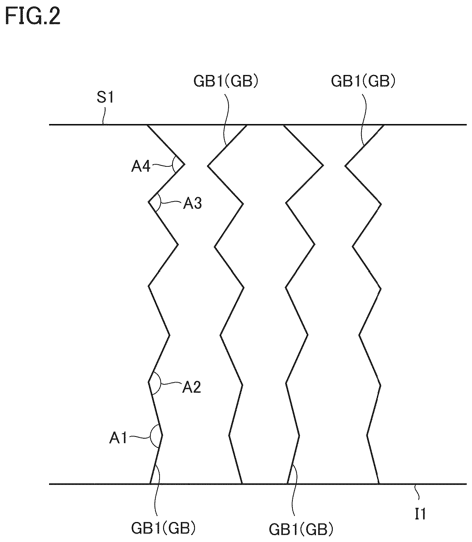

A cutting tool according to one embodiment of the present disclosure will be described with reference to Figs. 1 and 2. Fig. 1 is a schematic cross sectional view illustrating one implementation of a cutting tool of the present disclosure. Fig. 2 is an enlarged view of a region II in Fig. 1.

One embodiment of the present disclosure (hereinafter, also referred to as "the present embodiment") is directed to

a cutting tool 10 comprising: a substrate 1; and a coating film 2 disposed on substrate 1, wherein coating film 2 includes a first layer 3,

first layer 3 is composed of $\alpha$-Al$_2$O$_3$,

a thickness of first layer 3 is 2 $\mu$m or more and 15 $\mu$m or less,

in a cross section along a normal line of an interface between substrate 1 and coating film 2, first layer 3 includes a plurality of grain boundaries GB each connecting an interface I1 of first layer 3 close to substrate 1 and a surface S1 of first layer 3 or an interface of first layer 3 close to a surface of coating film 2, and a first grain boundary GB1, which is at least one of grain boundaries GB, has a plurality of straight line portions and three or more bending points each connecting two adjacent straight line portions of the straight line portions,

in first grain boundary GB 1, each of an intersection angle A1 at a bending point closest to interface I1 of first layer 3 close to substrate 1 and an intersection angle A2 at a bending point second closest to interface I1 of first layer 3 close to substrate 1 is 120° or more and less than 180°,

in first grain boundary GB 1, each of an intersection angle A4 at a bending point closest to surface S1 of first layer 3 or the interface of first layer 3 close to the surface of coating film 2 and an intersection angle A3 at a bending point second closest to surface S1 of first layer 3 or the interface of first layer 3 close to the surface of coating film 2 is 90° or more and 150° or less,

in first grain boundary GB1, an average X1 of intersection angle A1 and intersection angle A2 and an average X2 of intersection angle A3 and intersection angle A4 satisfy a relation of a formula 1, and

a ratio N2/N1 of the number N2 of first grain boundaries GB1 to the number N1 of grain boundaries GB is 0.2 or more, where

$$X1-X2 \geq 10° \quad \text{Formula 1.}$$

According to the present disclosure, it is possible to provide cutting tool 10 having an excellent tool life also particularly in face milling. A reason therefor is presumed as follows.

In cutting tool 10 of the present embodiment, in the cross section along the normal line of the interface between substrate 1 and coating film 2, first layer 3 includes the plurality of grain boundaries GB each connecting interface I1 of first layer 3 close to substrate 1 and surface S1 of first layer 3 or the interface of first layer 3 close to the surface of coating film 2, and first grain boundary GB1, which is at least one of grain boundaries GB, has the plurality of straight line portions and the three or more bending points each connecting two adjacent straight line portions of the straight line portions, in first grain boundary GB1, each of intersection angle A1 at the bending point closest to interface I1 of first layer 3 close to substrate 1 and intersection angle A2 at the bending point second closest to interface I1 of first layer 3 close to substrate 1 is 120° or more and less than 180°, in first grain boundary GB1, each of intersection angle A4 at the bending point closest to surface S1 of first layer 3 or the interface of first layer 3 close to the surface of coating film 2 and intersection angle A3 at the bending point second closest to surface S1 of first layer 3 or the interface of first layer 3 close to the surface of coating film 2 is 90° or more and 150° or less, in first grain boundary GB 1, average X1 of intersection angle A1 and intersection angle A2 and average X2 of intersection angle A3 and intersection angle A4 satisfy the relation of formula 1, and ratio N2/N1 of the number N2 of first grain boundaries GB1 to the number N1 of grain boundaries GB is 0.2 or more. Thus, since the intersection angle in the region of first layer 3 close to substrate 1 is sufficiently large, first layer 3 is facilitated to be strongly oriented, with the result that the wear resistance of first layer 3 can be improved also particularly in face milling. Moreover, since the intersection angle in the region of first layer 3 close to the surface of coating film 2, which has a particularly large load at the time of cutting, is sufficiently small, the grain boundary strength of first layer 3 can be facilitated to be improved, with the result that the chipping resistance of first layer 3 can be improved. Therefore, since both the wear resistance and the chipping resistance can be improved in first layer 3, it is possible to provide cutting tool 10 having an excellent tool life also particularly in face milling.

<<Cutting Tool>>

As shown in Figs. 1 and 2, cutting tool 10 according to one embodiment of the present disclosure includes substrate 1 and coating film 2 disposed on substrate 1. Coating film 2 preferably covers the entire surface of substrate 1, but a part of substrate 1 not covered with coating film 2 or coating film 2 having a partially different configuration is not deviated from the scope of the present embodiment. When a part of substrate 1 is not covered with coating film 2, coating film 2 is preferably disposed to cover a surface of at least a portion of substrate 1 involved in cutting. In the present specification, the portion of substrate 1 involved in cutting means a region of substrate 1 surrounded by its cutting edge ridgeline and an imaginary plane in which a distance from the cutting edge ridgeline toward substrate 1 along a line perpendicular to a tangent of the cutting edge ridgeline is, for example, any one of 5 mm, 3 mm, 2 mm, 1 mm, and 0.5 mm although it depends on the size and shape of substrate 1.

Cutting tool 10 according to the present embodiment can be suitably used as a cutting tool 10 such as a drill, an end mill, an indexable cutting insert for drill, an indexable cutting insert for end mill, an indexable cutting insert for milling (for example, face milling), an indexable cutting insert for turning, a metal saw, a gear cutting tool, a reamer, a tap, or the like.

<<Substrate>>

As substrate 1, any conventionally known substrate for this type of substrate 1 can be used. For example, substrate 1 is preferably any one of a cemented carbide (such as a WC-based cemented carbide, a cemented carbide including WC and Co, or a cemented carbide to which a carbonitride of Ti, Ta, Nb or the like is further added), a cermet (having TiC, TiN, TiCN, or the like as a main component), a high-speed steel, a ceramic (such as titanium carbide, silicon carbide, silicon nitride, aluminum nitride, or aluminum oxide), a cubic boron nitride sintered material, or a diamond sintered material.

Among these various types of substrates 1, the WC-based cemented carbide or the cermet (particularly, the TiCN-based cermet) is particularly preferably selected. Each of these substrates 1 is particularly excellent in balance between hardness and strength at a high temperature, and therefore can contribute to attaining a long life of cutting tool 10 when used as substrate 1 of cutting tool 10.

<<Coating Film>>

Coating film 2 includes first layer 3. Coating film 2 may consist only of first layer 3, or coating film 2 may include a layer other than first layer 3 ("other layer(s)" described later) as long as the effects of the present disclosure are not impaired. The thickness of coating film 2 may be 7 $\mu$m or more and 25 $\mu$m or less, or may be 10 $\mu$m or more and 15 $\mu$m or

less. When the thickness of coating film 2 is less than 7 $\mu$m, the life of cutting tool 10 tends to be likely to be short because the thickness of coating film 2 is too thin. On the other hand, when the thickness of coating film 2 is more than 25 $\mu$m, chipping of coating film 2 is likely to occur at the initial stage of cutting, with the result that the life of cutting tool 10 tends to be likely to be short.

The thickness of coating film 2 can be measured by using a scanning electron microscope (SEM) to observe a cross section of coating film 2 along a normal direction of the surface of coating film 2. Specifically, an observation magnification for the cross sectional sample is set to 5000 to 10000 times and an observation area is set to 100 to 500 $\mu$m$^2$ so as to measure thickness ranges at any three locations in any one visual field, and the average (arithmetic average) thereof is defined as the "thickness" thereof. The same applies to the thickness of each of below-described layers unless otherwise stated particularly.

<<First Layer>>

<Composition of First Layer>

First layer 3 is composed of $\alpha$-Al$_2$O$_3$. The expression "composed of $\alpha$-Al$_2$O$_3$" means that first layer 3 may consist only of $\alpha$-Al$_2$O$_3$, and can include an inevitable impurity in addition to $\alpha$-Al$_2$O$_3$ as long as the effects of the present disclosure are not impaired. Examples of the inevitable impurity include a chlorine atom (Cl), a sulfur atom (S), and the like. The total content ratio of the inevitable impurity in first layer 3 may be, for example, 0 mass% or more and 0.10 mass% or less, or 0.01 mass% or more and 0.05 mass% or less. It should be noted that in the present disclosure, it can be considered that $\alpha$-Al$_2$O$_3$ in first layer 3 exists as grains. Grain boundary GB described later means an interface between a grain and a grain adjacent thereto.

The fact that first layer 3 is composed of $\alpha$-Al$_2$O$_3$ is specified by X-ray diffraction (XRD) and energy dispersive X-ray spectroscopy (EDX). The content ratio of the inevitable impurity in first layer 3 is measured by secondary ion mass spectrometry (SIMS). It should be noted that as long as the measurement is performed on the same cutting tool 10, it has been confirmed that there is no variation in measurement results even when measurement locations are freely selected.

<Thickness of First Layer>

The thickness of first layer 3 is 2 $\mu$m or more and 15 $\mu$m or less. The thickness of first layer 3 may be 3 $\mu$m or more and 14 $\mu$m or less, 4 $\mu$m or more and 13 $\mu$m or less, or 5 $\mu$m or more and 12 $\mu$m or less.

<Surface Roughness Ra>

The thickness of first layer 3 may be less than 8 $\mu$m, and surface roughness Ra may be 0.03 $\mu$m or more and 0.2 $\mu$m or less in surface S1 of first layer 3 or a surface of first layer 3 located at the interface of first layer 3 close to the surface of coating film 2. Thus, local fracture of coating film 2 at the time of surface treatment can be suppressed, and residual stress can be facilitated to be applied uniformly, with the result that a more excellent tool life can be provided to cutting tool 10 also particularly in face milling. When the thickness of first layer 3 is less than 8 $\mu$m, surface roughness Ra may be 0.03 $\mu$m or more and 0.15 $\mu$m or less, or may be 0.03 $\mu$m or more and 0.1 $\mu$m or less.

The thickness of first layer 3 may be 8 $\mu$m or more, and surface roughness Ra may be 0.05 $\mu$m or more and 0.2 $\mu$m or less in surface S1 of first layer 3 or the surface of first layer 3 located at the interface of first layer 3 close to the surface of coating film 2. Thus, local fracture of coating film 2 at the time of surface treatment can be suppressed, and residual stress can be facilitated to be applied uniformly, with the result that a more excellent tool life can be provided to cutting tool 10 also particularly in face milling. When the thickness of first layer 3 is 8 $\mu$m or more, surface roughness Ra may be 0.05 $\mu$m or more and 0.18 $\mu$m or less, or may be 0.06 $\mu$m or more and 0.15 $\mu$m or less.

Surface roughness Ra is measured in accordance with JIS B0601:2001 in a cross section of a cutting edge R along the normal direction of the interface between substrate 1 and coating film 2. More specifically, first, an image including surface S1 of first layer 3 or the surface of first layer 3 located at the interface of first layer 3 on the surface side of coating film 2 is obtained by imaging the cross section of cutting edge R along the normal direction of the interface between substrate 1 and coating film 2 at a magnification of 1,000 times using an SEM. Next, in the image, any one observation visual field having a rectangular shape of 10 $\mu$m $\times$ 10 $\mu$m is specified at a magnification of 10,000 times. In the observation visual field, it is assumed that "surface S1 of first layer 3 or the surface of first layer 3 located at the interface of first layer 3 on the surface side of coating film 2" passes through a pair of any two sides facing each other. Next, the contour information of the interface is extracted from the observation visual field using image analysis software (ImageJ, version 1.51j8: https://imagej.nih.gov/ij/), thereby specifying the "arithmetic average roughness" of "surface S1 of first layer 3 or the surface of first layer 3 located at the interface of first layer 3 on the surface side of coating film 2" in the observation visual field. Next, in the image, the "arithmetic average roughness" of "surface S1 of first layer 3 or the surface of first layer 3 located at the interface of first layer 3 on the surface side of coating film 2" is specified in each of any other four observation visual fields. Next, the average (arithmetic average) of the "arithmetic average roughnesses" of "surface S1 of first layer 3 or the surface of first layer 3 located at the interface of first layer 3 on the surface side of coating film 2" in the total of the five observation visual fields is calculated to specify surface roughness Ra described above. It should be noted that as long as the measurement is performed on the same first layer 3, it has been confirmed that there is no variation in measurement results even when measurement locations are freely selected.

<Grain Boundaries>

In the cross section along the normal line of the interface between substrate 1 and coating film 2, first layer 3 includes the plurality of grain boundaries GB each connecting interface I1 of first layer 3 close to substrate 1 and surface S1 of first layer 3 or the interface of first layer 3 close to the surface of coating film 2. First grain boundary GB1, which is at least one of grain boundaries GB, has the plurality of straight line portions and the three or more bending points each connecting two adjacent straight line portions of the straight line portions. With these, the "chipping resistance" of first layer 3 can be improved.

In first grain boundary GB1, each of intersection angle A1 at the bending point closest to interface I1 of first layer 3 close to substrate 1 and intersection angle A2 at the bending point second closest to interface I1 of first layer 3 close to substrate 1 is 120° or more and less than 180°. In first grain boundary GB1, each of intersection angle A4 at the bending point closest to surface S1 of first layer 3 or the interface of first layer 3 close to the surface of coating film 2 and intersection angle A3 at the bending point second closest to surface S1 of first layer 3 or the interface of first layer 3 close to the surface of coating film 2 is 90° or more and 150° or less. In first grain boundary GB1, average X1 of intersection angle A1 and intersection angle A2 and average X2 of intersection angle A3 and intersection angle A4 satisfy the relation of formula 1:

$$X1\text{-}X2 \geq 10° \quad \text{Formula 1.}$$

The upper limit of each of intersection angle A1 and intersection angle A2 may be 175° or less, or may be 170° or less.

Ratio N2/N1 of the number N2 of first grain boundaries GB1 to the number N1 of grain boundaries GB is 0.2 or more. Thus, in first layer 3, wear resistance and chipping resistance can be further improved. The upper limit of ratio N2/N1 may be 1.0 or less, or may be 0.7 or less. Ratio N2/N1 may be 0.3 or more and 1.0 or less, may be 0.4 or more and 1.0 or less, or may be 0.5 or more and 1.0 or less.

Ratio N2/N1 can be specified by the following method.

(a1) The cross section of first layer 3 along the normal direction of the interface between coating film 2 and substrate 1 is subjected to an electron beam backscattering diffraction image analysis using a field emission scanning microscope, thereby creating a color map based on the respective crystal orientations of the grains (crystal grains).

(b1) Based on the color map created in (a1), an image in which grain boundary GB of any one grain (crystal grain) is white and the other portions are black is output, thereby obtaining a first image.

(c1) Pixels in respective columns in the first image are observed sequentially from the left end of the image, and a location at which the color is changed from black to white for the first time is specified as "any one grain boundary GB connecting interface I1 of the first layer close to the substrate and surface S1 of the first layer or the interface of the first layer close to the surface of the coating film".

(d1) For each of the pixels in the respective columns of grain boundary GB in the first image as specified in (c1), a rectangular region centered on the pixel and having a size of $15 \times 15$ pixels (i.e., $0.3\,\mu m \times 0.3\,\mu m$) is fitted by a linear expression to obtain an angle of grain boundary GB at each pixel.

(e1) When the angle of any pixel of grain boundary GB as determined in (d1) is maximum or minimum among the pixels of the grain boundary GB in columns at $0.4\,\mu m$ upward and downward with the column including the foregoing pixel being centered, the pixel is specified as a straight line portion. A location connecting this straight line portion and a straight line portion closer to the substrate of the first layer among straight line portions adjacent to each other along the grain boundary is specified as a bending point, and a value found by subtracting, from 180°, the absolute value of a difference in angle found in (d1) between the straight line portions is specified as an intersection angle at the bending point.

(f1) In the case where the plurality of straight line portions and the three or more bending points each connecting two adjacent straight line portions exist in grain boundary GB specified in (c1), intersection angle A1 at the bending point closest to interface I1 of the first layer close to the substrate and intersection angle A2 at the bending point second closest to interface I1 of first layer 3 close to substrate 1 are specified in the order from the substrate side of the first layer. Further, intersection angle A4 at the bending point closest to surface S1 of the first layer or the interface of the first layer close to the surface of the coating film and intersection angle A3 at the bending point second closest to surface S1 of the first layer or the interface of the first layer close to the surface of the coating film are specified in the order from surface S1 of the first layer or the interface of the first layer close to the surface of the coating film.

(g1) Average X1 is calculated by dividing, by 2, the sum of intersection angle A1 and intersection angle A2 specified in (f1). Further, average X2 is calculated by dividing, by 2, the sum of intersection angle A3 and intersection angle A4 specified in (f1).

(h1) (f1) to (g1) are performed onto each of "any other at least 17 grain boundaries GB each connecting interface I1 of the first layer close to the substrate and surface S1 of the first layer or the interface of the first layer close to the surface of the coating film", thereby specifying intersection angle A1, intersection angle A2, intersection angle A3, intersection angle A4, average X1, and average X2 for each of the any other at least 17 grain boundaries GB.

(i1) Among the total of the 18 or more grain boundaries GB, the number of grain boundaries GB (i.e., first grain boundaries GB1) in each of which each of intersection angle A1 and intersection angle A2 is 120° or more and less than 180°, each of intersection angle A4 and intersection angle A3 is 90° or more and 150° or less, and average X1 and average X2 satisfy the relation of formula 1 is divided by the number of grain boundaries GB (i.e., 18 or more), thereby specifying "ratio N2/N1 of the number N2 of first grain boundaries GB1 to the number N1 of grain boundaries GB".

It should be noted that as long as the measurement is performed on the same first layer 3, it has been confirmed that there is no variation in measurement results even when measurement locations are freely selected.

<Average D1 of Distances Between Two Adjacent Bending Points Along Normal Line of Interface Between Substrate and Coating Film>

In first grain boundary GB1, an average D1 of distances between two adjacent bending points along the normal line of the interface between substrate 1 and coating film 2 may be 0.05 $\mu$m or more and 4 $\mu$m or less. Thus, the bending strength of coating film 2 can be facilitated to be improved, with the result that a more excellent tool life can be provided to cutting tool 10 also particularly in face milling. Average D1 of the distances may be 0.06 $\mu$m or more and 3 $\mu$m or less, 0.07 $\mu$m or more and 2 $\mu$m or less, or 0.08 $\mu$m or more and 1 $\mu$m or less.

Average D1 of the distances can be specified by the following method.

(a2) Any one first grain boundary GB1 is specified by specifying intersection angle A1, intersection angle A2, average X1, and average X2 in grain boundary GB in the same manner as described in (a1) to (g1) above.

(b2) In first grain boundary GB1 specified in (a2), next, all the absolute values of differences between columns of two adjacent straight line portions at respective bending points along the grain boundary (in other words, assuming that the position of the terminal end of the first layer close to the substrate is 0 $\mu$m, the absolute values of differences in distance [$\mu$m] from the position along the normal direction of the interface between coating film 2 and substrate 1) are calculated, and the average (arithmetic average) of the absolute values of the differences is found to specify the average of the distances between the two adjacent bending points along the normal line of the interface between the substrate and the coating film.

(c2) For each of any other four first grain boundaries GB, the average of the distances between two adjacent bending points along the normal line of the interface between the substrate and the coating film is specified in the same manner as described in (a2) to (b2) above. The sum of the averages of the distances between the two adjacent bending points along the normal line of the interface between the substrate and the coating film in the total of the five first grain boundaries GB1 is divided by 5, thereby specifying average D1 of the distances.

It should be noted that as long as the measurement is performed on the same first layer 3, it has been confirmed that there is no variation in measurement results even when measurement locations are freely selected.

<Orientation Index TC(0 0 12) of First Layer>

An orientation index TC(0 0 12) of first layer 3 may be more than 4.5. Thus, the strength of the grains in first layer 3 (in other words, the $\alpha$-Al$_2$O$_3$ grains (crystal grains)) is further improved, with the result that the wear resistance of first layer 3 can be further improved. As a result, more excellent tool life can be provided to cutting tool 10 also particularly in face milling. The orientation index TC(0 0 12) of first layer 3 may be more than 4.5 and 8.0 or less, may be 5.0 or more and 7.9 or less, or may be 6.0 or more and 7.9 or less.

It should be noted that in the present specification, the "orientation index TC(0 0 12)" of first layer 3 means the orientation index TC(0 0 12) of the (0 0 12) plane in first layer 3 among orientation indices TC(hkl) defined by the following formula 2.

[Math. 1]

$$TC(hkl) = \frac{I(hkl)}{I_0(hkl)} \left\{ \frac{1}{n} \sum\nolimits_1^n \frac{I(hkl)}{I_0(hkl)} \right\}^{-1} \qquad \text{Formula 2}$$

In formula 2, I(hkl) represents the X-ray diffraction intensity of the (hkl) reflection plane, and $I_0$(hkl) represents the standard intensity according to the PDF card number 00-010-0173 of ICDD. Moreover, n in formula 2 indicates the number of reflections used in the calculation, and is 8 in the present embodiment. The (hkl) planes used for reflection are (012), (104), (110), (0 0 12), (113), (214), (116) and (300).

ICDD (registered trademark) is an abbreviation for International Centre for Diffraction Data (International Center for Diffraction Data). PDF (registered trademark) is an abbreviation for Powder Diffraction File.

It should be noted that the orientation index TC(0 0 12) of first layer 3 of the present embodiment can be expressed by the following formula 3:

[Math. 2]

$$TC(0\ 0\ 12) = \frac{I(0\ 0\ 12)}{I_0(0\ 0\ 12)} \left\{ \frac{1}{8} \sum\nolimits_1^8 \frac{I(hkl)}{I_0(hkl)} \right\}^{-1} \qquad \text{Formula 3}$$

Therefore, the expression "the orientation index TC(0 0 12) of first layer 3 is more than 4.5" means that a numerical value found by the above-described formula 3 obtained by substituting TC(0 0 12) into the above-described formula 2 is more than 4.5.

The measurement of TC(hkl) as described above can be performed by an analysis using an X-ray diffractometer. TC(hkl) can be measured under the following conditions by using, for example, SmartLab (registered trademark) (scan speed: 21.7°/min, step: 0.01°, scan range: 15 to 140°) provided by Rigaku. It should be noted that in the present embodiment, the result of the measurement of TC(hkl) by using the X-ray diffractometer is referred to as "XRD result".

(Conditions)

Characteristic X-ray: Cu-K$\alpha$
Tube voltage: 45 kV
Tube current: 200 mA
Filter: multilayer mirror
Optical system: concentration method
X-Ray diffraction: $\theta$-2$\theta$ method

When the X-ray diffractometer is used, X-ray is applied to the rake face of the cutting tool. Since the rake face is normally provided with unevenness and the flank face is flat, it is preferable to apply X-ray to the flank face in order to exclude a disturbance factor. In particular, X-ray is applied to a location located on the flank face and expanding in a range of about 2 to 4 mm from the cutting edge ridgeline portion. Thus, reproducibility of the result becomes high. It should be noted that in the present embodiment, the value of the orientation index TC(hkl) of first layer 3 on the flank face of the substrate is the same as the value of TC(hkl) of first layer 3 on the rake face of the substrate.

It should be noted that it has been confirmed that similar results are obtained even when a plurality of measurement locations are freely selected in the same sample and the above-described measurement is performed on each of the measurement locations.

<<Other Layer(s)>>

Examples of the other layer(s) include an underlying layer (not shown), an intermediate layer (not shown), a surface layer (not shown), and the like. The underlying layer is a layer in contact with substrate 1. The surface layer is a layer located on the surface of coating film 2. The intermediate layer is a layer disposed between the underlying layer and first layer 3 or a layer disposed between first layer 3 and the surface layer.

<Underlying Layer>

The underlying layer may be composed of TiN or TiCN. The expression "composed of TiN or TiCN" means that it may consist only of TiN or TiCN and may include an inevitable impurity or the like in addition to TiN or TiCN. Here, examples of the inevitable impurity include a chlorine atom (Cl), an oxygen atom (O), a cobalt atom (Co), a tungsten atom (W), a nickel atom (Ni), and a boron atom (B). The total content ratio of the inevitable impurity in the underlying layer may be, for example, 0 mass% or more and 1.0 mass% or less, or may be 0.3 mass% or more and 0.6 mass% or less.

The fact that the underlying layer is composed of TiN or TiCN is measured by the X-ray diffraction (XRD) method and the energy dispersive X-ray spectroscopy (EDX). The content ratio of the inevitable impurity in the underlying layer is measured by the secondary ion mass spectrometry (SIMS) method. It should be noted that as long as the measurement is performed on the same underlying layer, it has been confirmed that there is no variation in measurement results even when measurement locations are freely selected.

The thickness of the underlying layer may be 0.1 $\mu$m or more and 2.0 $\mu$m or less, 0.5 $\mu$m or more and 1.5 $\mu$m or less, or 0.8 $\mu$m or more and 1.3 $\mu$m or less.

<Intermediate Layer>

The intermediate layer may be composed of TiCN. The expression "composed of TiCN" means that it may consist only of TiCN and may include an inevitable impurity or the like in addition to TiCN. Here, examples of the inevitable impurity include a chlorine atom (Cl), an oxygen atom (O), a cobalt atom (Co), a tungsten atom (W), a nickel atom (Ni), and a boron atom (B). The total content ratio of the inevitable impurity in the intermediate layer may be, for example, 0 mass% or more and 1.0 mass% or less, or may be 0.3 mass% or more and 0.6 mass% or less.

The fact that the intermediate layer is composed of TiCN is measured by the X-ray diffraction (XRD) method and the energy dispersive X-ray spectroscopy (EDX). The content ratio of the inevitable impurity in the intermediate layer is measured by the secondary ion mass spectrometry (SIMS) method. It should be noted that as long as the measurement is performed on the same intermediate layer, it has been confirmed that there is no variation in measurement results even when measurement locations are freely selected.

The thickness of the intermediate layer may be 2.0 $\mu$m or more and 10 $\mu$m or less, or 4.0 $\mu$m or more and 8.0 $\mu$m or less.

<Surface Layer>

The surface layer may be composed of TiN. The expression "composed of TiN" means that it may consist only of TiN and may include an inevitable impurity or the like in addition to TiN. Here, examples of the inevitable impurity include a chlorine atom (Cl), an oxygen atom (O), a cobalt atom (Co), a tungsten atom (W), a nickel atom (Ni), and a boron atom (B). The total content ratio of the inevitable impurity in the surface layer may be, for example, 0 mass% or more and 1.0 mass% or less, or 0.1 mass% or more and 0.4 mass% or less.

The fact that the surface layer is composed of TiN is measured by the X-ray diffraction (XRD) method and the energy dispersive X-ray spectroscopy (EDX). The content ratio of the inevitable impurity in the surface layer is measured by the secondary ion mass spectrometry (SIMS) method. It should be noted that as long as the measurement is performed on the same surface layer, it has been confirmed that there is no variation in measurement results even when measurement locations are freely selected.

The thickness of the surface layer may be 0.5 $\mu$m or more and 3.0 $\mu$m or less, or may be 1.0 $\mu$m or more and 2.5 $\mu$m or less.

[Second Embodiment: Method of Manufacturing Cutting Tool]

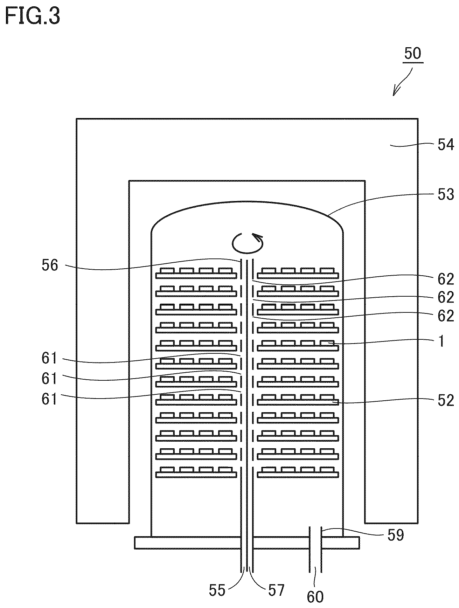

A method of manufacturing a cutting tool according to the present embodiment will be described with reference to Fig. 3. Fig. 3 is a schematic cross sectional view of an exemplary CVD apparatus used to manufacture the cutting tool of the present disclosure.

The method of manufacturing the cutting tool according to the present embodiment is a method of manufacturing the cutting tool described in the first embodiment, and includes: a first step of preparing substrate 1; and a second step of forming the coating film on substrate 1, wherein the second step includes a second-a step of forming the first layer by a CVD method. Details of each step will be described below.

<<First Step>>

In the first step, substrate 1 is prepared. As substrate 1, substrate 1 described in the first embodiment can be used.

For example, when cemented carbide is used as substrate 1, a commercially available substrate 1 may be used or a substrate may be produced using a general powder metallurgy method. In the production using the general powder metallurgy method, for example, WC powder, Co powder, and the like are mixed using a ball mill or the like to obtain a powder mixture. This powder mixture is dried and then is formed into a predetermined shape, thereby obtaining a molded material. Further, by sintering the molded material, a WC-Co based cemented carbide (sintered material) is obtained. Next, this sintered material is subjected to a predetermined cutting edge process such as honing, thereby manufacturing substrate 1 composed of the WC-Co based cemented carbide. Any conventionally known substrate other than substrate 1 described above can be prepared as this type of substrate 1.

<<Second Step>>

In the second step, the coating film is formed on substrate 1, thereby obtaining the cutting tool. The formation of the coating film is performed using, for example, a CVD apparatus 50 shown in Fig. 2. CVD apparatus 50 includes: a plurality of substrate setting jigs 52 for holding substrates 1; and a reaction container 53 that is composed of a heat-resistant alloy steel and that covers substrate setting jigs 52. Moreover, a temperature adjustment apparatus 54 for controlling a temperature in reaction container 53 is provided around reaction container 53. Reaction container 53 is provided with a gas introduction pipe having a gas introduction port. The gas introduction pipe extends in the vertical direction in an inner space of reaction container 53 in which substrate setting jigs 52 are disposed, is disposed to be rotatable with respect to the vertical direction, and is provided with a plurality of jetting holes (through holes) for jetting gas into reaction container 53. By using this CVD apparatus 50, the first layer included in the coating film can be formed as follows.

The second step includes the second-a step of forming the first layer by the CVD method. When the coating film includes the "other layer(s)" described in the first embodiment, the second step can further include a step of forming each of the "other layer(s)". The other layer(s) can be formed by a conventional method.

<Second-a Step: Step of Forming First Layer by CVD Method>

In the second-a step, the first layer is formed by the CVD method. More specifically, first, substrate 1 is disposed on substrate setting jig 52, and a source gas for the first layer is introduced into reaction container 53 from the gas introduction pipe while controlling the temperature and pressure in reaction container 53 to fall within predetermined ranges. Thus, the first layer is formed on substrate 1.

In CVD apparatus 50, a nozzle 56 having two introduction ports 55, 57 is disposed. Nozzle 56 is disposed to extend through a region in which substrate setting jig 52 is disposed. The plurality of jetting holes (a first jetting hole 61, a second jetting hole 62, a third jetting hole (not shown), and a fourth jetting hole (not shown)) are formed in a portion of nozzle 56 near substrate setting jig 52.

Gases introduced into nozzle 56 from introduction ports 55, 57 are not mixed even in nozzle 56, pass through different jetting holes, and are introduced into reaction container 53. Nozzle 56 can be rotated around its axis as a center axis. An exhaust pipe 59 is disposed in CVD apparatus 50, and the exhaust gas can be discharged to outside through an exhaust port 60 of exhaust pipe 59. It should be noted that the jigs and the like in reaction container 53 are each normally composed of graphite.

As the source gas, a mixed gas of $AlCl_3$, HCl, $CO_2$, $H_2S$, and $H_2$ is used.

First, in order to form a region of the first layer close to the substrate, (001) film formation and (110) film formation are alternately performed repeatedly under the below-described conditions (step I). In step I, a film formation time in the (001) film formation is 4 to 90 minutes, and the rotation speed of the nozzle in the (001) film formation is 0.2 to 2 rpm. In step I, a film formation time in the (110) film formation is 4 to 90 minutes, and the rotation speed of the nozzle in the (110) film formation is 0.4 to 4 rpm. Next, in order to form a region of the first layer close to the surface of the coating film, (001) film formation and (110) film formation are alternately performed repeatedly under the below-described conditions (step II). In step II, a film formation time in the (001) film formation is 5 to 180 minutes, and the rotation speed of the nozzle in the (001) film formation is 0.5 to 4 rpm. Moreover, in step II, a film formation time in the (110) film formation is 5 to 180 minutes, and the rotation speed of the nozzle in the (110) film formation is 0.5 to 6 rpm. The rotation speed of the nozzle in the (001) film formation in step I is lower, by 0.1 rpm or more, than the rotation speed of the nozzle in the (001) film formation in step II. In other words, "(the rotation speed of the nozzle in the (001) film formation in step I) - (the rotation speed of the nozzle in the (001) film formation in step II)" is -0.1 rpm or less. The rotation speed of the nozzle in the (001) film formation in step I may be lower, by 0.5 rpm or more or by 1 rpm or more, than the rotation speed of the nozzle in the (001) film formation in step II. The rotation speed of the nozzle in the (110) film formation in step I is lower, by 0.1 rpm or more, than the rotation speed of the nozzle in the (110) film formation in step II. In other words, "(the rotation speed of the nozzle in the

(110) film formation in step I) - (the rotation speed of the nozzle in the (110) film formation in step II)" is -0.1 rpm or less. The rotation speed of the nozzle in the (110) film formation in step I may be lower, by 0.5 rpm or more or by 1 rpm or more, than the rotation speed of the nozzle in the (110) film formation in step II. The sum of the number of times of performing the (001) film formation in step I and the number of times of performing the (001) film formation in step II is two or more, and the sum of the number of times of performing the (110) film formation in step I and the number of times of performing the (110) film formation in step II is two or more. Thus, the first grain boundary having the plurality of straight line portions and the three or more bending points each connecting two adjacent straight line portions can be formed. It should be noted that the (001) film formation is performed by jetting the mixed gas from first jetting hole 61 and second jetting hole 62, and the (110) film formation is performed by jetting the mixed gas from the third jetting hole (not shown) and the fourth jetting hole (not shown). In each of step I and step II, the (001) film formation may be performed first or the (110) film formation may be performed first.

<Conditions of (001) Film Formation>

$AlCl_3$: 0.005 to 0.02 volume%
HCl: 0.01 to 0.05 volume%
$CO_2$: 1.5 to 6.0 volume%
$H_2S$: 0.3 to 1.0 volume%
$H_2$: remainder
Temperature: 950 to 1050°C
Pressure: 50 to 200 hPa
Flow rate: 15 to 60 L/min

<Conditions of (110) Film Formation>

$AlCl_3$: 0.01 to 0.04 volume%
HCl: 0.01 to 0.05 volume%
$CO_2$: 2.5 to 10 volume%
$H_2S$: 0.02 to 0.08 volume%
$H_2$: remainder
Temperature: 950 to 1050°C
Pressure: 50 to 150 hPa
Flow rate: 20 to 40 L/min

Each of the number of times of performing the (001) film formation and the number of times of performing the (110) film formation is not particularly limited. By appropriately adjusting each of the number of times of performing the (001) film formation and the number of times of performing the (110) film formation, the thickness of the first layer can be adjusted.

<Other Step>

The second step can include a surface treatment step such as surface grinding or blasting in addition to the above-described steps.

<<Feature of Method of Manufacturing Cutting Tool According to the Present Embodiment>>

In the method of manufacturing the cutting tool according to the present embodiment, in the second-a step, after alternately performing the (001) film formation in which the film formation time is 4 to 90 minutes and the condition of the rotation speed of the nozzle is 0.2 to 2 rpm and the (110) film formation in which the film formation time is 4 to 90 minutes and the condition of the rotation speed of the nozzle is 0.4 to 4 rpm (step I), the (001) film formation in which the film formation time is 5 to 180 minutes and the condition of the rotation speed of the nozzle is 0.5 to 4 rpm and the (110) film formation in which the film formation time is 4 to 180 minutes and the condition of the rotation speed of the nozzle is 0.5 to 6 rpm are alternately performed (step II). The (001) film formation is performed by jetting the mixed gas from the first jetting hole and the second jetting hole, and the (110) film formation is performed by jetting the mixed gas from the third jetting hole and the fourth jetting hole. The rotation speed of the nozzle in the (001) film formation in step I is lower, by 0.1 rpm or more, than the rotation speed of the nozzle in the (001) film formation in step II, and the rotation speed of the nozzle in the (110) film formation in step I is lower, by 0.1 rpm or more, than the rotation speed of the nozzle in the (110) film formation in step II. The sum of the number of times of performing the (001) film formation in step I and the number of times of performing the (001) film formation in step II is two or more, and the sum of the number of times of performing the (110) film formation in step I and the number of times of performing the (110) film formation in step II is two or more. With these, the intersection angle at the grain boundary can be suppressed to be relatively small in the region of the first layer close to the surface of the coating film while the intersection angle at the grain boundary is relatively large in the region of the first layer close to the substrate. Therefore, intersection angle A1, intersection angle A2, intersection angle A3, intersection angle A4, average X1 of intersection angle A1 and intersection angle A2, and average X2 of intersection angle A3 and intersection angle A4 can be adjusted to fall within respective desired ranges, and ratio N2/N1 of the number N2 of the first grain boundaries to the number N1 of grain boundaries can be adjusted to fall within a desired range. As a result of diligent study by the present inventors, it has been found that the cutting tool of the present disclosure can be realized by employing such a manufacturing method.

Examples

The present embodiment will be described more specifically with reference to examples. However, the present embodiment is not limited by these examples.

<<Production of Cutting Tool>>

Each of cutting tools according to samples 1 to 19 and 101 to 104 was produced as follows.

<<First Step>>

As a substrate, a milling insert (Shape: WGC4160R; provided by Sumitomo Electric HardMetal) having the following composition was prepared.

(Composition of Substrate)

Co content ratio: 9.5 mass%
$Cr_3C_2$ content ratio: 1.0 mass%
WC content ratio: remainder

<<Second Step>>

By performing the CVD method, a first layer was formed on the surface of the substrate (second-a step). First, for each of samples 1 to 19, sample 101, sample 102, and sample 104, (001) film formation in which a film formation time was as described in Table 1 and the condition of the rotation speed of the nozzle was as described in Table 1 and (110) film formation in which a film formation time was as described in Table 1 and the condition of the rotation speed of the nozzle was as described in Table 1 were alternately performed a number of times as described in the column "Number of Repetitions [times]" of Table 1 (step I). Next, for each of samples 1 to 19, sample 101, sample 102, and sample 104, (001) film formation in which a film formation time was as shown in Table 2 and the condition of the rotation speed of the nozzle was as shown in Table 2 and (110) film formation in which a film formation time was as shown in Table 2 and the condition of the rotation speed of the nozzle was as shown in Table 2 were alternately performed by the number of times described in the column "Number of Repetitions [times]" of Table 2 (step II). Further, for sample 103, (001) film formation in which a film formation time was as shown in Table 1 and the condition of the rotation speed of the nozzle was as shown in Table 1 was performed once (step I). For sample 103, step II was not performed. It should be noted that for each of samples 1 to 19 and samples 101 to 103, the number of the jetting holes in the (001) film formation was "two", and the number of the jetting holes in the (110) film formation was "two". For sample 104, the number of the jetting holes in the (001) film formation was "one", and the number of the jetting holes in the (110) film formation was "one". In each of step I and step II, the (001) film formation was performed first. Each of "(the rotation speed of the nozzle in the (001) film formation in step I) - (the rotation speed of the nozzle in the (001) film formation in step II)" and "(the rotation speed of the nozzle in the (110) film formation in step I) - (the rotation speed of the nozzle in the (110) film formation in step II)" was as shown in Table 3. For each of the (001) film formation and the (110) film formation, conditions other than the film formation time and the rotation speed of the nozzle were as follows.

<Conditions of (001) Film Formation>

AlCl$_3$: 0.01 volume%
HCl: 0.025 volume%
CO$_2$: 3.20 volume%
H$_2$S: 0.64 volume%
H$_2$: remainder
Temperature: 1000°C
Pressure: 100 hPa
Flow rate: 35 L/min

<Conditions of (110) Film Formation>

AlCl$_3$: 0.02 volume%
HCl: 0.025 volume%
CO$_2$: 5.00 volume%
H$_2$S: 0.04 volume%
H$_2$: remainder
Temperature: 1000°C
Pressure: 100 hPa
Flow rate: 30 L/min

Next, blasting was performed onto the surface of the first layer under the following conditions.

(Conditions)

Type of media: ceramics
Average particle size of media: 50 $\mu$m
Density of media: 100 g/min
Projection angle: 75°
Projection distance: 35 mm
Projection pressure: as described in Table 3
Time: 10 seconds
Rotation speed of cutting tool: 60 rpm

In this way, the cutting tools according to samples 1 to 19 and 101 to 104 were produced.

[Table 1]

Table 1

| Sample No. | Second-a Step | | | | |
| | Step I | | | | |
| | (001) Film Formation | | (110) Film Formation | | Number of Repetitions [times] |
| | Film Formation Time [min] | Rotation Speed of Nozzle [rpm] | Film Formation Time [min] | Rotation Speed of Nozzle [rpm] | |
| 1 | 15 | 1 | 15 | 1 | 4 |
| 2 | 60 | 0.5 | 60 | 0.5 | 18 |
| 3 | 20 | 1.4 | 20 | 1.8 | 10 |
| 4 | 5 | 2 | 5 | 4 | 100 |
| 5 | 90 | 0.5 | 60 | 0.5 | 4 |

(continued)

| Sample No. | Second-a Step | | | | |
| --- | --- | --- | --- | --- | --- |
| | Step I | | | | Number of Repetitions [times] |
| | (001) Film Formation | | (110) Film Formation | | |
| | Film Formation Time [min] | Rotation Speed of Nozzle [rpm] | Film Formation Time [min] | Rotation Speed of Nozzle [rpm] | |
| 6 | 4 | 2 | 4 | 2 | 100 |
| 7 | 50 | 0.2 | 30 | 0.6 | 4 |
| 8 | 30 | 0.5 | 30 | 1 | 4 |
| 9 | 24 | 0.2 | 12 | 0.4 | 4 |
| 10 | 35 | 0.5 | 8 | 0.5 | 9 |
| 11 | 60 | 0.8 | 20 | 0.6 | 4 |
| 12 | 50 | 0.8 | 44 | 0.5 | 5 |
| 13 | 60 | 0.5 | 60 | 0.5 | 2 |
| 14 | 30 | 0.5 | 30 | 1 | 4 |
| 15 | 50 | 0.8 | 44 | 0.9 | 7 |
| 16 | 50 | 0.8 | 30 | 1.4 | 12 |
| 17 | 50 | 1.2 | 44 | 1.5 | 13 |
| 18 | 60 | 0.8 | 60 | 1 | 8 |
| 19 | 50 | 0.9 | 80 | 1.5 | 6 |
| 101 | 5 | 1.5 | 5 | 2 | 12 |
| 102 | 60 | 0.5 | 60 | 1 | 9 |
| 103 | 120 | 2 | - | - | - |
| 104 | 60 | 1 | 60 | 1 | 5 |

[Table 2]

Table 2

| Sample No. | Second-a Step | | | | | Sum of Numbers of Repetitions [times] |
| --- | --- | --- | --- | --- | --- | --- |
| | Step II | | | | Number of Repetitions [times] | |
| | (001) Film Formation | | (110) Film Formation | | | |
| | Film Formation Time [min] | Rotation Speed of Nozzle [rpm] | Film Formation Time [min] | Rotation Speed of Nozzle [rpm] | | |
| 1 | 15 | 2 | 15 | 2 | 4 | 8 |
| 2 | 90 | 1 | 90 | 1 | 4 | 22 |
| 3 | 30 | 2 | 20 | 2 | 8 | 18 |
| 4 | 8 | 4 | 6 | 6 | 90 | 190 |
| 5 | 120 | 1 | 120 | 1 | 3 | 7 |
| 6 | 5 | 4 | 5 | 4 | 100 | 200 |
| 7 | 160 | 1 | 140 | 1 | 3 | 7 |
| 8 | 60 | 1 | 60 | 2 | 4 | 8 |

(continued)

| Sample No. | Second-a Step | | | | | |
| | Step II | | | | | Sum of Numbers of Repetitions [times] |
| | (001) Film Formation | | (110) Film Formation | | Number of Repetitions [times] | |
| | Film Formation Time [min] | Rotation Speed of Nozzle [rpm] | Film Formation Time [min] | Rotation Speed of Nozzle [rpm] | | |
| 9 | 44 | 0.5 | 28 | 0.5 | 2 | 6 |
| 10 | 40 | 1 | 38 | 1 | 3 | 12 |
| 11 | 45 | 1 | 45 | 1 | 2 | 6 |
| 12 | 38 | 1 | 34 | 1 | 2 | 7 |
| 13 | 90 | 1 | 90 | 1 | 2 | 4 |
| 14 | 60 | 1 | 60 | 2 | 10 | 14 |
| 15 | 40 | 1 | 32 | 1 | 10 | 17 |
| 16 | 65 | 1 | 38 | 2 | 12 | 24 |
| 17 | 60 | 2 | 60 | 2 | 11 | 24 |
| 18 | 40 | 1 | 100 | 2 | 6 | 14 |
| 19 | 30 | 1 | 120 | 2 | 5 | 11 |
| 101 | 8 | 2 | 4 | 2 | 8 | 20 |
| 102 | 100 | 1 | 80 | 1 | 4 | 13 |
| 103 | - | - | - | - | - | - |
| 104 | 60 | 1 | 60 | 1 | 8 | 13 |

[Table 3]

Table 3

| Sample No. | Second-a Step | | Blasting |
| | (Rotation Speed of Nozzle in (001) Film Formation of Step I) (Rotation Speed of Nozzle in (001) Film Formation of Step II) [rpm] | (Rotation Speed of Nozzle in (110) Film Formation of Step I) (Rotation Speed of Nozzle in (110) Film Formation of Step II ) [rpm] | Projection Pressure [MPa] |
| 1 | -1 | -1 | 0.2 |
| 2 | -0.5 | -0.5 | 0.3 |
| 3 | -0.6 | -0.2 | 0.2 |
| 4 | -2 | -2 | 0.2 |
| 5 | -0.5 | -0.5 | 0.3 |
| 6 | -2 | -2 | 0.2 |
| 7 | -0.8 | -0.4 | 0.3 |
| 8 | -0.5 | -1 | 0.2 |
| 9 | -0.3 | -0.1 | 0.2 |
| 10 | -0.5 | -0.5 | 0.2 |
| 11 | -0.2 | -0.4 | 0.2 |
| 12 | -0.2 | -0.5 | 0.2 |

(continued)

| Sample No. | Second-a Step | | Blasting |
|---|---|---|---|
| | (Rotation Speed of Nozzle in (001) Film Formation of Step I) (Rotation Speed of Nozzle in (001) Film Formation of Step II) [rpm] | (Rotation Speed of Nozzle in (110) Film Formation of Step I) (Rotation Speed of Nozzle in (110) Film Formation of Step II ) [rpm] | Projection Pressure [MPa] |
| 13 | -0.5 | -0.5 | 0.2 |
| 14 | -0.5 | -1 | 0.3 |
| 15 | -0.2 | -0.1 | 0.3 |
| 16 | -0.2 | -0.6 | 0.3 |
| 17 | -0.8 | -0.5 | 0.3 |
| 18 | -0.2 | -1 | 0.3 |
| 19 | -0.1 | -0.5 | 0.3 |
| 101 | -0.5 | 0 | 0.2 |
| 102 | -0.5 | 0 | 0.3 |
| 103 | - | - | 0.20 |
| 104 | 0 | 0 | 0.3 |

[Table 4]

Table 4

| Sample No. | Coating Film | | | | | | | | Cutting Test 1 | Cutting Test 2 |
|---|---|---|---|---|---|---|---|---|---|---|
| | First Layer | | | | | | | | | |
| | Composition | Thickness [$\mu$m] | N1 [number] | N2 [number] | N2/N1 | D1 [$\mu$m] | Ra [$\mu$m] | TC (0012) | Time [min] | Time [min] |
| 1 | $\alpha$-$Al_2O_3$ | 2 | 20 | 5 | 0.3 | 0.5 | 0.1 | 4.8 | 4.5 | 7.8 |
| 2 | $\alpha$-$Al_2O_3$ | 15 | 20 | 14 | 0.7 | 3 | 0.14 | 8.0 | 12.0 | 6.0 |
| 3 | $\alpha$-$Al_2O_3$ | 4 | 20 | 4 | 0.2 | 0.4 | 0.08 | 4.9 | 7.5 | 6.6 |
| 4 | $\alpha$-$Al_2O_3$ | 4 | 20 | 5 | 0.3 | 0.05 | 0.05 | 4.8 | 7.5 | 7.8 |
| 5 | $\alpha$-$Al_2O_3$ | 15 | 18 | 12 | 0.7 | 4 | 0.15 | 8.1 | 10.5 | 6.0 |
| 6 | $\alpha$-$Al_2O_3$ | 4 | 22 | 6 | 0.3 | 0.04 | 0.06 | 5.0 | 6.0 | 9.0 |
| 7 | $\alpha$-$Al_2O_3$ | 15 | 20 | 10 | 0.5 | 5.00 | 0.16 | 8.1 | 9.0 | 6.0 |
| 8 | $\alpha$-$Al_2O_3$ | 7 | 22 | 16 | 0.7 | 1.5 | 0.12 | 7.6 | 9.0 | 9.0 |
| 9 | $\alpha$-$Al_2O_3$ | 5 | 25 | 15 | 0.6 | 2.4 | 0.03 | 6.5 | 9.0 | 9.0 |
| 10 | $\alpha$-$Al_2O_3$ | 5 | 27 | 14 | 0.5 | 1.3 | 0.2 | 6.8 | 7.5 | 8.4 |
| 11 | $\alpha$-$Al_2O_3$ | 5 | 24 | 16 | 0.7 | 1.5 | 0.02 | 7.2 | 9.0 | 9.0 |
| 12 | $\alpha$-$Al_2O_3$ | 5 | 22 | 8 | 0.4 | 1.2 | 0.30 | 7.6 | 6.8 | 9.0 |
| 13 | $\alpha$-$Al_2O_3$ | 8 | 21 | 15 | 0.7 | 3 | 0.12 | 7.7 | 9.0 | 9.0 |
| 14 | $\alpha$-$Al_2O_3$ | 10 | 20 | 12 | 0.6 | 1.5 | 0.05 | 7.8 | 9.0 | 9.0 |
| 15 | $\alpha$-$Al_2O_3$ | 10 | 19 | 14 | 0.7 | 1.2 | 0.2 | 8.0 | 7.5 | 7.8 |
| 16 | $\alpha$-$Al_2O_3$ | 12 | 22 | 15 | 0.7 | 1.4 | 0.04 | 6.1 | 9.0 | 10.0 |
| 17 | $\alpha$-$Al_2O_3$ | 12 | 22 | 10 | 0.5 | 1 | 0.32 | 7.6 | 8.0 | 10.0 |

(continued)

| Sample No. | Coating Film | | | | | | | | Cutting Test 1 | Cutting Test 2 |
| | First Layer | | | | | | | | | |
| | Composition | Thickness [μm] | N1 [number] | N2 [number] | N2 / N1 | D1 [μm] | Ra [μm] | TC (0012) | Time [min] | Time [min] |
|---|---|---|---|---|---|---|---|---|---|---|
| 18 | $\alpha$-Al$_2$O$_3$ | 12 | 22 | 15 | 0.7 | 1.5 | 0.06 | 4.6 | 10.5 | 6.6 |
| 19 | $\alpha$-Al$_2$O$_3$ | 12 | 25 | 17 | 0.7 | 1.5 | 0.04 | 4.4 | 10.5 | 6.0 |
| 101 | $\alpha$-Al$_2$O$_3$ | 1 | 30 | 13 | 0.4 | 0.1 | 0.05 | 4.8 | 3.0 | 9.0 |
| 102 | $\alpha$-Al$_2$O$_3$ | 18 | 18 | 11 | 0.6 | 3 | 0.15 | 8.2 | 12.0 | 5.4 |
| 103 | $\alpha$-Al$_2$O$_3$ | 3 | 20 | 2 | 0.1 | 0.3 | 0.1 | 6.2 | 4.5 | 5.4 |
| 104 | $\alpha$-Al$_2$O$_3$ | 15 | 20 | 0 | 0 | 2 | 0.1 | 8.2 | 3.0 | 5.0 |

<<Evaluations on Properties of Cutting Tool>>

<Composition of First Layer>

For the cutting tool according to each sample, the composition of the first layer was found by the method described in the first embodiment. The obtained results are shown in the column "Composition" of the column "First Layer" of Table 4. It should be noted that when the name of the component is described in the column "Composition" of the column "First Layer" in Table 4, it means that the first layer is composed of the component represented by the name of the component.

<Thickness of First Layer>

For the cutting tool according to each sample, the thickness of the first layer was found by the method described in the first embodiment. The obtained results are shown in the column "Thickness [μm]" of the column "First Layer" of Table 4.

<Ratio N2/N1>

For the cutting tool according to each sample, each of the number N1 of grain boundaries, the number N2 of first grain boundaries, and ratio N2/N1 was found by the method described in the first embodiment. The obtained results are shown in the column "N1 [number]", the column "N2 [number]", and the column "N2/N1" in Table 4.

<Average D1 of Distances Between Two Adjacent Bending Points Along Normal Line of Interface Between Substrate and Coating Film>

For the cutting tool according to each sample, an average D1 of distances between two adjacent bending points along the normal line of the interface between the substrate and the coating film in the first grain boundary was found by the method described in the first embodiment. The obtained results are shown in the column "D1 [μm]" of Table 4.

<Surface Roughness Ra in Surface of First Layer or Interface of First Layer on Surface Side of Coating Film>

In the surface of the first layer or the surface of the first layer located at the interface of the first layer on the surface side of the coating film, surface roughness Ra was found by the method described in the first embodiment. The obtained results are shown in the column "Ra [μm]" in Table 4.

<Orientation Index TC(0 0 12) of First Layer>

For the cutting tool according to each sample, the orientation index TC(0 0 12) of the first layer was found by the method described in the first embodiment. The obtained results are shown in the column "TC (0012)" of the column "First Layer" in Table 4.

<<Cutting Test 1>>

The cutting tool according to each sample was used to perform cutting under the following cutting conditions. Among a period of time from the start of the cutting to a time when the flank face wear (Vb) became more than 0.2 mm and a period of time from the start of the cutting to a time when chipping occurred, a shorter period of time was measured. The obtained results are shown in the column "Time [min]" of the column "Cutting Test 1" of Table 4.

(Cutting Conditions)

Workpiece: SCM435 block material
Processing method: face milling
Processing speed V: 250 m/min
Feed rate f: 0.3 mm/rev
Cut-in depth ap: 2.0 mm
Cutting liquid: present

The above cutting conditions correspond to cutting conditions for face milling.

<<Cutting Test 2>>

The cutting tool according to each sample was used to perform cutting under the following cutting conditions. A period of time from the start of the cutting until occurrence of breakage was measured as a cutting time. It should be noted that when no breakage occurred after passage of 5 minutes, the cutting time was regarded as 10 minutes. The obtained results are shown in the column "Time [min]" of the column "Cutting Test 2" of Table 4.

(Cutting Conditions)

Workpiece: S50C block material
Processing method: face milling
Processing speed V: 200 m/min
Feed rate f: 0.4 mm/rev
Cut-in depth ap: 2.0 mm
Cutting liquid: none

The above cutting conditions correspond to cutting conditions for face milling.
When the time is 4.5 minutes or more in cutting test 1 and the time is 6.0 minutes or more in cutting test 2, it means that the cutting tool has an excellent tool life.
Each of the cutting tools according to samples 1 to 19 corresponds to an example of the present disclosure. Each of the cutting tools according to samples 101 to 104 corresponds to a comparative example. From the results of cutting test 1 and the results of cutting test 2 in Table 4, it was found that each of the cutting tools according to samples 1 to 19 had a more excellent tool life than that of each of the cutting tools according to samples 101 to 104.
In view of the above, it was found that each of the cutting tools according to samples 1 to 19 had an excellent tool life.
Although the embodiments and examples of the present disclosure have been described as described above, it is also initially expected to appropriately combine or variously modify the configurations of the above-described embodiments and examples.
The embodiments and examples disclosed herein are illustrative and non-restrictive in any respect. The scope of the present invention is defined by the terms of the claims, rather than the embodiments and examples described above, and is intended to include any modifications within the scope and meaning equivalent to the terms of the claims.

REFERENCE SIGNS LIST

1 substrate; 2 coating film; 3 first layer; 10 cutting tool; 50 CVD apparatus; 52 substrate setting jig; 53 reaction container; 54 temperature adjustment apparatus; 55, 57 introduction port; 56 nozzle; 59 exhaust pipe; 60 discharge port;

**EP 4 729 217 A1**

61 first jetting hole; 62 second jetting hole; GB grain boundary; GB1 first grain boundary; S1 surface; I1 interface.

**Claims**

1. A cutting tool comprising: a substrate; and a coating film disposed on the substrate, wherein

   the coating film includes a first layer,
   the first layer is composed of $\alpha$-Al$_2$O$_3$,
   a thickness of the first layer is 2 $\mu$m or more and 15 $\mu$m or less,
   in a cross section along a normal line of an interface between the substrate and the coating film, the first layer includes a plurality of grain boundaries each connecting an interface of the first layer close to the substrate and a surface of the first layer or an interface of the first layer close to a surface of the coating film, and a first grain boundary, which is at least one of the grain boundaries, has a plurality of straight line portions and three or more bending points each connecting two adjacent straight line portions of the straight line portions,
   in the first grain boundary, each of an intersection angle A1 at a bending point closest to the interface of the first layer close to the substrate and an intersection angle A2 at a bending point second closest to the interface of the first layer close to the substrate is 120° or more and less than 180°,
   in the first grain boundary, each of an intersection angle A4 at a bending point closest to the surface of the first layer or the interface of the first layer close to the surface of the coating film and an intersection angle A3 at a bending point second closest to the surface of the first layer or the interface of the first layer close to the surface of the coating film is 90° or more and 150° or less,
   in the first grain boundary, an average X1 of the intersection angle A1 and the intersection angle A2 and an average X2 of the intersection angle A3 and the intersection angle A4 satisfy a relation of a formula 1, and
   a ratio N2/N1 of the number N2 of the first grain boundaries to the number N1 of the grain boundaries is 0.2 or more, where

$$X1\text{-}X2 \geq 10° \quad \text{Formula 1.}$$

2. The cutting tool according to claim 1, wherein in the first grain boundary, an average D1 of distances between two adjacent bending points along the normal line of the interface between the substrate and the coating film is 0.05 $\mu$m or more and 4 $\mu$m or less.

3. The cutting tool according to claim 1 or 2, wherein

   the thickness of the first layer is less than 8 $\mu$m, and
   in the surface of the first layer or a surface of the first layer located at the interface of the first layer close to the surface of the coating film, a surface roughness Ra is 0.03 $\mu$m or more and 0.2 $\mu$m or less.

4. The cutting tool according to claim 1 or 2, wherein

   the thickness of the first layer is 8 $\mu$m or more, and
   in the surface of the first layer or a surface of the first layer located at the interface of the first layer close to the surface of the coating film, a surface roughness Ra is 0.05 $\mu$m or more and 0.2 $\mu$m or less.

5. The cutting tool according to any one of claims 1 to 4, wherein an orientation index TC(0 0 12) of the first layer is more than 4.5.

FIG.1

FIG.2

FIG.3

## INTERNATIONAL SEARCH REPORT

| International application No. |
|---|
| **PCT/JP2024/017150** |

### A. CLASSIFICATION OF SUBJECT MATTER

***B23B 27/14*** (2006.01)i
FI: B23B27/14 A

According to International Patent Classification (IPC) or to both national classification and IPC

### B. FIELDS SEARCHED

Minimum documentation searched (classification system followed by classification symbols)

B23B27/14; B23B51/00; B23C5/16; B23P15/28; C23C16/40

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | EP 2902528 A1 (WALTER AG) 05 August 2015 (2015-08-05) | 1-3, 5 |
| | paragraphs [0039], [0061]-[0081], tables 3-4, 6, fig. 3 | |
| Y | | 4 |
| Y | WO 2017/009928 A1 (SUMITOMO ELECTRIC HARDMETAL CORP.) 19 January 2017 (2017-01-19) | 4 |
| | paragraphs [0052]-[0054], [0105]-[0108], table 11 | |
| A | JP 2013-63504 A (MITSUBISHI MATERIALS CORPORATION) 11 April 2013 (2013-04-11) | 1-5 |
| | paragraph [0018], fig. 3 | |

☐ Further documents are listed in the continuation of Box C.    ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
|---|---|
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **11 June 2024** | **25 June 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

## INTERNATIONAL SEARCH REPORT
### Information on patent family members

International application No.

**PCT/JP2024/017150**

| Patent document cited in search report | | | Publication date (day/month/year) | Patent family member(s) | | | Publication date (day/month/year) |
|---|---|---|---|---|---|---|---|
| EP | 2902528 | A1 | 05 August 2015 | WO | 2015/113866 | A1 | |
| WO | 2017/009928 | A1 | 19 January 2017 | US | 2017/0189968 | A1 | |
| | | | | paragraphs [0060]-[0064], [0142]-[0150], table 11 | | | |
| | | | | EP | 3323538 | A1 | |
| | | | | CN | 106660136 | A | |
| | | | | KR | 10-2018-0025780 | A | |
| JP | 2013-63504 | A | 11 April 2013 | US | 2014/0287210 | A1 | |
| | | | | paragraph [0102], fig. 3 | | | |
| | | | | EP | 2752264 | A1 | |
| | | | | CN | 103764323 | A | |
| | | | | KR | 10-2014-0063666 | A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2015113866 A

**Non-patent literature cited in the description**

- **S. RUPPI et al.** Influence of Process Conditions on the Growth and Texture of CVD Alpha-Alumina. *Coatings*, 2020, vol. 10, 158